# EUROPEAN PATENT SPECIFICATION

(11) **EP 2 026 132 B1**
(45) Date of publication and mention of the grant of the patent: **13.03.2013**
(21) Application number: 08014041.1
(22) Date of filing: 06.08.2008
(51) Int. Cl.: G03F 7/24, G03F 7/18, B29C 63/14

(54) **Process for making a cylindrically-shaped photosensitive element for use as a printing form**
Verfahren zur Herstellung eines zylindrisch geformten lichtempfindlichen Elements zur Verwendung als Druckform
Procédé pour la fabrication d'un élément photosensible de forme cylindrique pour une utilisation en tant que forme d'impression

(30) Priority: 16.08.2007 US 965046 P
(43) Date of publication of application: 18.02.2009
(73) Proprietor: E. I. Du Pont de Nemours and Company, Wilmington, DE 19898 (US)
(72) Inventor: Knudsen, Thies, 63067 Offenbach/M. (DE); Riechert, Stephan, 60599 Frankfurt (DE); Taylor, Bradley K., West Chester, Pennsylvania 19382 (US)
(74) Representative: Hoffmann, Benjamin

(56) References cited:
- EP-A1- 0 280 922
- WO-A2-2004/092841
- DE-A1- 2 722 896
- DE-A1-102004 050 277
- DE-A1-102005 037 909
- GB-A- 2 017 570

## Description

### BACKGROUND OF THE INVENTION

### 1. Field of the Disclosure

This invention relates to a process for making a cylindrically-shaped photosensitive element for use as a printing form, in particular for use as a relief printing form.

### 2. Description of Related Art

Flexographic printing plates are well known for use in printing, particularly on surfaces which are soft and easily deformable, such as packaging materials, e.g., cardboard, plastic films, etc. Flexographic printing plates can be prepared from photopolymerizable compositions, such as those described in U.S. patents 4,323,637 and 4,427,749. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, polymerization, and hence, insolubilization of the photopolymerizable layer occurs in the exposed areas. Treatment with a suitable solvent removes the unexposed areas of the photopolymerizable layer leaving a printing relief which can be used for flexographic printing.

Photopolymerizable materials can be formed into sheets or layers by several known methods such as solvent casting, hot pressing, calendering and extrusion. A preferred method of forming photopolymerizable materials for use as flexographic printing elements is by extrusion calendering the photopolymerizable material. In extrusion calendering, the printing element is prepared by passing a mass of hot photopolymerizable material into an extrusion die forming a layer, passing the layer into the nip of a calender and, while still hot, calendering the photopolymerizable material between two flat surfaces, generally two flexible films, to form a multilayer web. The films can include multiple layers or compound films. After extrusion and calendering at elevated temperatures, the web can be held in tension while the multilayer web is cooled, for example, with blown air. The printing element as a multilayer web can be cut into suitable size sheets. Extrusion and calendering of polymeric compositions are disclosed, for example, in Gruetzmacher et al., U.S. Patent 4,427,759.

Although typically photopolymerizable printing elements are used in sheet form, there are particular applications and advantages to using the printing element in a continuous cylindrical form. Continuous printing elements have applications in the flexographic printing of continuous designs such as in wallpaper, decoration and gift wrapping paper, and tight-fit conditions for registration, since the designs can be easily printed without print-through of the plate seam. Furthermore, such continuous printing elements are well-suited for mounting on laser exposure equipment where it can replace the drum or be mounted on the drum for exposure by a laser to achieve precise registration. In addition, registration of multicolor images is greatly enhanced and facilitated by mounting cylindrically-shaped printing forms on a printing press.

The formation of seamless, continuous printing elements can be accomplished by several methods. The photopolymerizable flat sheet elements can be reprocessed by wrapping the element around a cylindrical form, usually a printing sleeve support or the printing cylinder itself, and then heating to join the edges together to form a seamless, continuous element. Processes for joining the edges of a plate into a cylindrical form have been disclosed, for example, in German patent DE 28 44 426, United Kingdom patent GB 1 579 817, European patent application EP 0 469 375, U.S. Patent 4,883,742, and U.S. Patent 4,871,650. These processes can take extended periods of time to completely form the cylindrical printing element since the sheet is heated after wrapping to bring the sheet up to a temperature to join the edges.

In particular, U.S. Patent 4,883,742 discloses seamless and firm joining of the end and/or lateral areas of thermoplastically processible photosensitive layers by overlapping the ends and/or areas to avoid bubbles and entrapment of air in between. The total layer material is heated under pressure and with joining of overlapping ends/areas resulting in a continuously joined photosensitive layer. In many methods of forming the continuous photosensitive element, the continuously joined photosensitive layer is typically ground to provide the desired thickness uniformity of the photopolymer layer and surface characteristics for the printing form. Hereto, the total layer of material is heated after application of the layers to the support, which may take additional time to heat the layers sufficiently to fuse together. DE 10 2004 050 277 teaches to heat only the contact surface between the photosensitive layer and the cylindrical support.

Although sometimes described as optional, the elements formed by these methods often require an adhesion promoting surface or layer between the support and the photopolymerizable layer. An exterior surface of the sleeve support or the printing cylinder may be covered with a (double-sided) tape, or coated with an adhesive material to assure that the photopolymerizable layer is retained to the sleeve or cylinder. It is particularly desirable to avoid the need to apply tape or an adhesive material between the sleeve support and the photopolymerizable layer since the application of an adhesive adds time and increases the complexity to the process of making the cylindrical elements.

The adhesive material, typically applied as a layer on the exterior surface of the sleeve support, should have a uniform thickness and be defect free. Non-uniform application of the adhesive material can alter the transmission of the actinic radiation during exposure or appear as density variation/s particularly after back exposure (through the support and adhesive layer) in the continuous printing form. Density variation/s in the printing form may actually cause or may provide the perception that the form will not print as desired. Sometimes bubbles can even form in the adhesive layer as a result of temperatures and/or solvents used to convert the continuous printing element into a continuous relief printing form. The appearance of bubbles or other such defects in the applied adhesive layer cause loss of adhesion of the photopolymer layer. Impression on press during printing can cause the bubbles in the adhesive layer to become larger such that the photopolymer layer may lift in part or in whole from the continuous printing form. Additionally, bubbles in the adhesive layer can cause non-uniformities in printing areas resulting in missed printing. Bubbles can also cause differences in the compressibility of the continuous printing form resulting in differences in ink-transfer during printing. It is also possible that bubbles in the photopolymer layer can materialize on an exterior surface of the photopolymer layer after grinding.

U.S. Patent 4,337,220 discloses a process for preparing photosensitive resin cylinders that includes winding a photosensitive resin sheet on and around an adhesive covered surface of a cylinder without any material overlapping of or spaces between the edge portions of the wound resin sheet, and applying to the cylinder under rotation a roll rotating in contact with the surface of the resin sheet while heating so as to join the edge potions of the resin sheet to one another by melting and to make uniform the thickness of the resin sheet. Heating after application of the resin sheet to the cylinder can take additional time to heat the layers sufficiently to join together. In addition, an adhesive tape or agent is necessary for the resin sheet to adhere to the cylinder.

Further, photosensitive resin cylinders are also made from a layer of photopolymeric composition by a Seamex process. The Seamex process involves wrapping a layer of photopolymeric material to a nickel sleeve having a heat-activated primer coat to bond with the material so that the ends of the plate are joined together. The entire assembly is placed in an oven to cure and bond the photopolymeric layer to the primer coat and melt ends of the photopolymeric layer together. The photopolymeric layer on the sleeve is then ground to the necessary thickness, wiped clean and sprayed with a protective coating to prevent negatives from sticking to the photopolymer during exposure. However, the process of wrapping, curing and melting, grinding and spraying the photopolymeric layer to the sleeve takes about 1.5 to 2 days to accomplish.

U.S. Patents 5,798,019 and 5,916,403 disclose an apparatus and a process for forming a cylindrical photosensitive element of uniform thickness on a flexible sleeve without sanding, grinding or additional polishing steps. The method involves supplying a stream of molten photopolymerizable material onto the sleeve supported directly on a mandrel, calendering the molten photopolymerizable material to have a substantially constant thickness on the sleeve, moving the sleeve around and along the mandrel in a helical fashion to polish an outer surface of the element, and during the calendering step, heating the photopolymerizable material. In a first mode, the flexible sleeve is mounted on an air lubricated mandrel such that the air permits the rotational and axial movement of the flexible sleeve, and the stream of molten photopolymerizable material is fed into a gap between the sleeve and a calender roll. In a second mode, the flexible sleeve is mounted onto a mandrel with the calender rolls positioned around the sleeve at the predefined clearance. A solid sheet of photopolymerizable material is fed into the gap between the sleeve and the calender roll. Once there is coverage of the photopolymerizable material around the circumference of the sleeve, the contact of the photopolymerizable material with the calender rolls will rotate the sleeve. During calendering, the solid sheet is heated beyond its glass transition temperature to permit metering of the sheet. However, this process requires considerable capital investment in equipment to provide the variety of sizes (e.g., inside diameters or repeat lengths, and widths of printing form) to accommodate the needs of the printing industry.

Thus, there is a need for an easy, relatively quick and productive method for making cylindrically-shaped photosensitive elements.

### SUMMARY

In accordance with this invention there is provided a process for making a cylindrically-shaped photosensitive element for use as a printing form as defined in claim 1. The process comprises providing a cylindrically-shaped support having an exterior surface, which has no tape or adhesive an its exterior surface; and providing a photosensitive layer comprising a thermoplastic binder, monomer, and photoinitiator, the layer having a first end and a second end opposite the first end joined by a contact surface. The process comprises contacting the contact surface of the photosensitive layer to the exterior surface of the support by wrapping the photosensitive layer around the support to bring the second end adjacent the first end; and laminating the photosensitive layer to the support and sealing the ends together to form a continuous layer on the support; wherein a preheating step is performed prior to the contacting step and is selected from the group consisting of 1) preheating the exterior surface of the support to a temperature greater than 39°C prior to actually contacting the 2) preheating the contact surface of the photosensitive layer to a temperature less than its glass transition temperature; and a combination of 1) and 2).

There is also described an apparatus for making a cylindrically-shaped photosensitive element from a cylindrically-shaped support having an exterior surface, and a photosensitive layer having a first end and a second end opposite the first end joined by a contact surface. The apparatus comprising means for supporting the support; means for positioning the photosensitive layer adjacent the support; means for preheating the exterior surface of the support adjacent the means for supporting; means for contacting the contact surface of the photosensitive layer to the exterior surface of the support by wrapping the photosensitive layer around the support to being the second end adjacent the first end; and means for laminating the photosensitive layer to the support and sealing the ends together to form a continuous layer on the support.

### BRIEF DESCRIPTION OF THE DRAWINGS

The invention can be more fully understood from the following detailed description thereof in connection with the accompanying drawing described as follows:
Figure 1 is a schematic side view of one embodiment of a step in the process of the present invention showing providing a layer of a photosensitive composition in a nip between a laminating roll and a base roller that is supporting a cylindrically-shaped support.
Figure 2 is a schematic side view of one embodiment of a step in the process of the present invention showing preheating the photosensitive layer and the support.
Figure 3 is a schematic side view of one embodiment of a step in the process of the present invention showing contacting the photosensitive layer onto the support.

### DESCRIPTION OF THE PREFERRED EMBODIMENTS

Throughout the following detailed description, similar reference characters refer to similar elements in all figures of the drawings.

The present invention provides a process for making a cylindrically-shaped photosensitive element for use as a printing form. In some embodiments the printing form is particularly suited for relief printing, including use as a flexographic printing form and letterpress printing form. Relief printing is a method of printing in which the printing form prints from an image area, where the image area of the printing form is raised and the non-image area is depressed. In some embodiments, the printing form is suited for gravure or gravure-like printing. Gravure printing is a method of printing in which the printing form prints from an image area, where the image area is depressed and consists of small recessed cups or wells to contain the ink or printing material, and the non-image area is the surface of the form. Gravure-like printing is similar to gravure printing except that a relief printing form is used wherein the image area is depressed and consists of recesses areas forming wells to carry the ink which transfer during printing. The process is quick, providing a cylindrically shaped photosensitive element from a formed layer of photosensitive composition in minutes, versus days required by other methods. The process is easy, securely providing the photosensitive layer directly on the cylindrical support avoiding a step to apply an adhesive material to the support and associated potential for defects in the applied adhesive layer and in the resulting cylindrical printing form. The process can optionally also avoid using a cylindrically-shaped support having an exterior surface that needs to be treated to promote adhesion of the photosensitive layer to the support. It is unexpected that preheating the cylindrically-shaped support and/or photosensitive layer is sufficient to adhere the photosensitive layer onto the support. It is unexpected and surprising that preheating the support and/or the photosensitive layer prior to contact of the layer and support provides sufficient heat to at least seal the ends of the layer together and form continuous layer on the support. It is unexpected and surprising that preheating the support and/or the photosensitive layer prior to contact of the layer and support can provide sufficient heat to seal and fuse the ends of the layer together and form a continuous layer on the support. The photosensitive element is adapted after imagewise exposure and treatment to become a cylindrical printing element having a surface suitable for printing. In some embodiments the surface is a relief surface suitable for relief printing. In some embodiments, the surface is a ink receptive cell surface, suitable for gravure or gravure-like printing.

The process includes providing a cylindrically-shaped support having an exterior surface. Opposite the exterior surface the cylindrically-shaped support includes an interior surface that is adjacent an outer surface of a base roll associated with a device for forming the cylindrically shaped photosensitive element. When mounted on press, the interior surface of the cylindrically-shaped support is also adjacent an outer surface of a print cylinder or adapter mounted onto the print cylinder. The cylindrically-shaped support, which may also be referred to herein as a sleeve, or base sleeve, or sleeve support, carries the photosensitive layer and provides the cylindrical element with the capability to be readily mounted and dismounted from the print cylinder and the base roll. The sleeve should be able to grip the base roll without rotational slippage. The sleeve, as part of a cylindrically-shaped printing form should also be able to grip the print cylinder without slippage. The sleeve can be held on the base roll without slippage by any means, including friction fit or interference fit. The fit used to hold the sleeve to the base roll can be the same or different than the fit used to hold the sleeve to the print cylinder. For friction fit, the sleeve is slid onto the base roll (or print cylinder) and held in position by friction between an interior surface of the sleeve and the outer surface of the base roll (or print cylinder). In some embodiments, the base roll has an outer diameter that is less than an inner diameter of the sleeve support, so that the support can slide onto the base roll and be held for rotation by friction between the sleeve and the base roll. For interference fit, the sleeve should be expandable typically with 20 to 100 psig air generally available in printing facilities. The sleeve should expand sufficiently for it to easily slide over the base roll (or print cylinder), so that an expansion exceeding the amount of interference fit is required. A typical interference fit with a base roll or the print cylinder is 3 to 15 mils, but is not so limited. In some embodiments, the sleeve is mounted onto the base roll and held using a friction fit. In other embodiments, the sleeve is mounted on the base roll and held using interference fit. In most embodiments interference fit is suited to securely mount the cylindrical printing form onto the print cylinder.

Provided that the sleeve support can be mounted on the base roll and the print cylinder with appropriate fit, the material/s and structure/s used to form the sleeve is not particularly limited. The sleeve can be formed of any material or combination of materials conventionally used in forming sleeves for printing. The sleeve can have a single layer, multi-layer, composite, unitary structure. The sleeve should be constructed such that it is homogeneous regarding flexibility, durometer, etc., but can include elements such as small strips or filaments for stabilization provided that such elements do not influence the capability of the continuous printing form to print. In some embodiments, the sleeve includes a layer of a resin composition that forms at least the exterior surface of the sleeve support. In some embodiments, the support is formed of one or more layers of material and includes as its exterior surface a layer of the resin composition. In some embodiments the support is formed entirely of a layer of the resin composition. In some embodiments the support is formed of a resin composition having fillers and/or fibers. The support formed of a resin composition reinforced with fiber is an example of a composite sleeve. In some embodiments the support is formed of one or more layers of resin composition that can be the same or different. Materials suitable as the resin composition are not limited, provided that the layer of resin does not melt or flow upon preheating to attach the photosensitive layer to the sleeve support. Examples of suitable resin materials include epoxy resins; polystyrene and polyvinyl resins, such as polyvinyl chloride and polyvinyl acetate; phenolic resins; and aromatic amine-cured epoxy resins. In some embodiments the resin may include fillers or can be fiber reinforced. The fibers used in the resin composition are not limited and can include, for example, glass fibers, aramid fibers, carbon fibers, metal fibers, and ceramic fibers. Fibers incorporated with the sleeve can include continuous, woven, and/or wound materials. An example of a suitable sleeve is described in U.S. 6,703,095. In one embodiment the sleeve support is selected from the group consisting of a fiber-reinforced polymeric resin or plastic. In some embodiments, the sleeve support is transparent to ultraviolet radiation to accommodate backflash exposure for building a floor in the cylindrical printing form. The sleeve has a (wall) thickness from about 0.01 and about 6.35 mm or more. In some embodiments, the sleeve has a thickness between about 0.25 and 0.75 mm. In some embodiments the sleeve has a thickness between about 0.30 and 0.70 mm. In some embodiments the sleeve has a thickness between about 0.60 and 0.80 mm. In some embodiments, the sleeve has a thickness between about 1 and 3 mm. In some embodiments, the sleeve includes a layer of a resin composition as its exterior surface that has a thickness between 0.05 and 0.09 mm.

Other materials also suitable for use as the sleeve support or in combination with sleeve made of the resin composition as described above include those materials that are conventionally used as a support for photosensitive elements used to prepare printing plates. The sleeve may be formed from single layer or multiple layers of flexible material. Examples of suitable flexible materials for use in the sleeve include polymeric films, such as those formed by addition polymers and linear condensation polymers, and foams and fabrics, such as fiberglass. In some embodiments flexible materials are transparent to ultraviolet radiation to accommodate backflash exposure for building a floor. The sleeve support may also include non-transparent, actinic radiation blocking materials, such as nickel or glass epoxy. Under certain end-use conditions, metals such as aluminum may also be used as a layer in the support, even though a metal support is not transparent to radiation. Multiple layered sleeves may include an adhesive layer or tape between the layers of flexible material, such as disclosed in U.S. Patent 5,301,610, or have an adhesive treatment such as flame or electron treatment.

The process includes the step of providing a layer of a photosensitive composition. Any thermoplastically processible solid photosensitive layer that can be joined to itself under the influence of heat and pressure without its photosensitive properties being adversely affected are suitable for use. This include, in particular, the solid, polymeric, photosensitive layers which soften on heating or exhibit adhesive bonding under pressure as known per se for the production of printing relief plates. The solid photosensitive layer includes at least a thermoplastic binder, monomer, and photoinitiator. As used herein, the term "solid" refers to the physical state of the layer that has a definite volume and shape and resists forces that tend to alter its volume or shape. The photosensitive layer is generally considered a solid at room temperature.

The photosensitive layer can be sheet-like, belt-like, or strip-like. In one embodiment, the photosensitive layer to be used according to the invention may be unsupported in order to permit firm contact attachment with the sleeve and fusing of the ends and/or lateral areas of the photosensitive layer with formation of a continuous homogeneous layer. Some embodiments use a self-supporting photosensitive layer. In some embodiments it is also possible for the photosensitive layer used to first be applied to a temporary support for example a plastic film, which is then removed, for example, by peeling it off, directly before the photosensitive layer is used in the process.

In some embodiments the layer of photosensitive composition may originate from a photosensitive element suitable for use a printing plate, that is, the element may include at least a flexible (sheet) support, the photosensitive layer, a release layer on the photosensitive layer, and a coversheet. In some embodiments, the sheet support includes a silicon-based surface or layer that promotes easy release from the photosensitive layer. In some embodiments the layer of photosensitive composition may originate from a photosensitive layer formed between two sheet supports having the silicon-based surface or layer. One or more additional layers, e.g., elastomeric cap layer, may be included in the element that can transfer with the photosensitive layer to the cylindrical support. At least the sheet support or the coversheet (as well as the release layer) are removed from a side of the photosensitive layer that will be adjacent the exterior surface of the sleeve support, prior to preheating of the photosensitive layer or prior to contact of the photosensitive layer to the support. The sheet support or the coversheet (and release layer) that remains can be removed in some embodiments prior to contacting, or prior to laminating, and in other embodiments removed after contacting the photosensitive layer to the sleeve support. In some embodiments the provided photosensitive layer has a thickness that is equal to or greater than a thickness of the continuous photosensitive layer formed on the sleeve.

The photosensitive layer includes a first end and a second end generally opposite the first end that are joined by a contact surface. The first end and the second end may be any ends of the layer of photosensitive composition that when wrapped about the cylindrical support, can at least be adjacent to one another in order to form the layer into a cylinder. In some embodiments, the first end and the second end may be distal ends. In some embodiments, the first end and the second end may be lateral ends or edges. The photosensitive layer need not be cut exactly to size. The layer can be cut such that when the layer is wrapped on the sleeve the first end and the second end are adjacent. The first end and the second end can be considered adjacent if the first end and the second end mate, abutt, overlap, or even form a small gap (e.g., about 0.5 to 1 mm, or up to about half of the thickness of the photosensitive layer). The layer can be cut to any desired shape including, for example, square, rectangular, trapezoidal, and in the form of a parallelogram. The ends that will at least be adjacent when cylindrically oriented may be trimmed or may be trimmed to mate with each other. Typically the ends are trimmed prior to preheating the photosensitive layer. The ends may be perpendicular or at an angle relative to a planar surface (i.e., the contact surface or exterior surface) of the photosensitive layer. The ends may be beveled, chamfered, or wedge-shaped. The contact surface of the photosensitive layer is the surface of the layer that comes in direct contact with the exterior surface of the cylindrically-shaped support.

Optionally, the photosensitive layer may be overall exposed to actinic radiation to form a floor of a shallow layer of polymerized material in the layer, prior to preheating. Overall exposure to form a floor is often referred to as a backflash exposure. In an embodiment where the photosensitive layer is backflash exposed prior to contacting the layer to the support, the backflash exposure is given to the contact surface of the photosensitive layer since the floor that is formed will be adjacent to the support. In some embodiments, the backflash exposure occurs after the sheet support (if present) is removed from the contact surface of the photosensitive layer. In other embodiments, the backflash exposure occurs before the sheet support (if present) is removed from the contact surface of the photosensitive layer. Back flash time can range from a few seconds to about 10 minutes. The backflash exposure can sensitize the photosensitive layer, help highlight dot resolution and also establish the depth of relief for the printing form. The floor provides better mechanical integrity to the photosensitive element. In some embodiments, the backflash exposure can occur after the cylindrically-shaped photosensitive element is formed provided that the cylindrical support is transparent to the actinic radiation. In this instance the exposure to form the floor may also improve adhesion of the photosensitive layer to the support.

The process includes preheating the sleeve support and/or the photosensitive layer prior to contacting the support and the photosensitive layer. The sleeve support and/or the photosensitive layer is preheated to a temperature sufficient to effect the attachment of the photosensitive layer to the sleeve support without the need for any adhesive material or tape on the exterior surface on the support. The exterior surface of the sleeve support and/or the contact surface of the photosensitive layer is preheated to assure that the two surfaces are capable of attaching upon contacting due to the tacky nature of the thermoplastic photosensitive layer. In some embodiments the exterior surface of the sleeve support is only preheated to a temperature sufficient to attach, or bond, or join the photosensitive layer to the sleeve, but not so high as to cause the sleeve to distort or deform or degrade. In some embodiments, the exterior surface of the sleeve is preheated to a temperature greater than 39°C to attach the photosensitive layer to the sleeve support. In some embodiments, preheating of the exterior surface creates a heat sink-like effect in the sleeve, rendering the sleeve capable of transferring heat from the sleeve to the photosensitive layer during contact of the photosensitive layer with the sleeve, and causing the photosensitive layer to become sufficiently tacky to attach to the sleeve. In some embodiments, preheating the exterior surface of the sleeve heats the entire sleeve support through in depth (i.e., through entire wall thickness to interior surface). In other embodiments, preheating the exterior surface of the sleeve heats only the surface or a partial depth of the wall thickness of the sleeve. Preheating the exterior surface of an embodiment of the sleeve that is composed of a resin composition to greater than 39°C enables the photosensitive layer to attach to the support. In some embodiments the exterior surface of the sleeve can be heated between 40°C and 75°C. In some embodiments the exterior surface of the sleeve can be heated between 40°C and 95°C. In some embodiments the exterior surface of the sleeve can be heated between 40°C and 105°C.

In some embodiments only the contact surface of the photosensitive layer is preheated to a temperature less than the glass transition temperature of the photosensitive layer which is sufficient to effect the attachment or bonding or joining of the photosensitive layer to the support without the need for any adhesive material or tape between the support and layer. In some embodiments, preheating of the contact surface causes the photosensitive layer to become sufficiently tacky to attach to the exterior surface of the sleeve. In some embodiments, preheating the contact surface of the photosensitive layer heats the entire layer through in depth thickness. In other embodiments, preheating the contact surface of the photosensitive layer heats only the contact surface or a partial depth of the thickness of the layer. Heating the contact surface of the photosensitive layer to less than its glass transition temperature enables the photosensitive layer to attach to the support, without causing the layer to flow or melt. It is desirable to avoid preheating the photosensitive layer to a temperature that causes the thermoplastic material to melt or flow since this can cause thickness non-uniformity of the layer. In some embodiments, the contact surface of the photosensitive layer can be heated between 40°C and 100°C. In some embodiments the exterior surface of the sleeve can be heated between 40°C and 75°C. In some embodiments the exterior surface of the sleeve can be heated between 40°C and 65°C. In some embodiments the exterior surface of the sleeve can be heated between 40°C and 55°C.

The photosensitive layer melts or flows at the glass transition temperature. The material of the photosensitive layer is usually a viscoelastic material which does not have a sharp transition between a solid and a liquid, and thus the glass transition temperature may not have a sharp transition temperature between a solid and a liquid state. Preheating of the photosensitive layer to less than its glass transition temperature avoids the viscoelastic material from flowing or melting. Preheating the photosensitive layer to any temperature sufficient cause the layer to soften and/or become tacky, but below the threshold to flow or melt, is suitable. In some embodiments, the contact surface of the photosensitive layer may be preheated to a temperature at least 10°C lower than its glass transition temperature. In some embodiments, the contact surface of the photosensitive layer may be preheated to a temperature at least 30°C lower than its glass transition temperature. In some embodiments, the contact surface of the photosensitive layer may be preheated to a temperature at least 60°C lower than its glass transition temperature. In some embodiments, the contact surface of the photosensitive layer may be preheated to a temperature at least 100°C lower than its glass transition temperature. However throughout this specification the term "softening" may be used to describe the behavior of the preheated photosensitive layer, regardless of whether the composition may or may not have a sharp transition temperature between a solid and a liquid state. A wide temperature range may be utilized to "soften" the photosensitive layer for the purposes of this invention. Sealing as well as fusing of the ends may be slower at lower temperatures and faster at higher temperatures during successful operation of the process.

Both the exterior surface of the sleeve support and the contact surface of the photosensitive layer can be preheated prior to contacting the support and the photosensitive layer. In some embodiments, the exterior surface and the contact surface are both preheated to the same or substantially the same temperature. In other embodiments, the exterior surface and the contact surface are both preheated to different temperatures. In other embodiments, the exterior surface of the sleeve is preheated to a temperature higher than a preheat temperature for the contact surface of the photosensitive layer. In other embodiments, the contact surface of the photosensitive layer is preheated to a temperature higher than a preheat temperature for the exterior surface of the sleeve. In some embodiments, the contact surface and the exterior surface are preheated to at least 40°C. In some embodiments, the contact surface and the exterior surface are preheated between 40°C and 100°C.

In some embodiments, the exterior surface and/or the contact surface is preheated in 10 minutes or less. In some embodiments, the exterior surface and/or the contact surface is preheated in 5 minutes or less. In some embodiments, the exterior surface and/or the contact surface is preheated in 1 minute or less. The amount of time to preheat the exterior surface and/or the contact surface to a temperature suitable to attach the photosensitive layer to the sleeve support and seal, or seal and fuse, the ends is dependent at least on the sleeve composition, the photosensitive composition, the thickness of the sleeve, the thickness of the photosensitive layer, if one or both the exterior surface of the sleeve and the contact surface of the photosensitive layer are heated, the method of heating, the proximity of the heat source to the exterior surface and/or contact surface, etc.

The exterior surface of the support sleeve and/or the contact surface of the photosensitive layer can be heated by any suitable heating means including conduction, convection, radiation, and combinations thereof, to a temperature sufficient to effect the attachment of the photosensitive layer to the sleeve support. In some embodiments, the exterior surface and/or the contact surface can be quickly heated by a radiant energy source, such as an infrared heating lamp. One or more radiant energy sources can be used to preheat the contact surface and/or the exterior surface. In other embodiments, the exterior surface and/or the contact surface can be heated by contact with a heated roll or drum, preferably having a non-stick surface. In some embodiments, the exterior surface of the sleeve and/or the contact surface of the photosensitive layer can be rotated or transported by one or more heat sources that are stationary. In other embodiments, the heat source can be moved relative to the photosensitive layer and/or the exterior surface. A different source of heat or the same source of heat used to preheat the exterior surface can be used to preheat the photosensitive layer.

Preheating is performed prior to the contacting of the photosensitive layer and the sleeve. It should be understood that preheating of the exterior surface and/or the contact surface can occur on portions of the sleeve and/or layer that are not yet contacted while other portions of the sleeve and layer are contacted together.

The process includes contacting the contact surface of the photosensitive layer to the exterior surface of the support by wrapping the photosensitive layer around the support to bring the second end adjacent the first end. Contacting brings the photosensitive layer in direct contact with the sleeve support. A roll located adjacent the base roll can be used for contacting the sleeve and the photosensitive layer to assure good contact with no air entrapment between the sleeve and the layer. The roll, which may also be referred to as a laminating roll, forms a nip with the sleeve mounted on the base roll and the photosensitive layer therebetween. The laminating roll and/or the base roll include means for relative motion such that a distance between the exterior surface of the sleeve and the laminating roll at the nip, i.e., gap, can be changed to apply pressure at the nip to the photosensitive layer on the support. In some embodiments, the laminating roll can have impression setting between 0 to 1 mm of displacement of the roll in the gap. An impression setting of 0 represents the distance at the nip being equal or substantially equal to the thickness of the photosensitive layer. An impression setting of 1 mm represents the distance at the nip being about 1 mm less than the thickness of the photosensitive layer. In some embodiments, the roll can have impression setting between 0 and 0.5 mm. The means for relative motion also can accommodate making cylindrically-shaped photosensitive elements having photosensitive layers with different thickness.

The photosensitive layer is contacted to the sleeve support by capturing the first end (a leading end) of the layer in the nip between the support mounted on a base roll and the laminating roll, rotating the base roll and laminating roll thereby contacting the exterior surface of the support with the contact surface of the photosensitive layer and wrapping the photosensitive layer onto the support. Since the laminating roll, in one embodiment at least provides intimate contact of the layer with the sleeve, and in other embodiments presses the photosensitive layer to the sleeve, air does not become entrapped between the photosensitive layer and the support. The base roll (with the support) rotates at least about 1 full revolution, i.e., 360 degrees, wrapping the photosensitive layer onto the support and bringing the first end and the second at least adjacent one another. In some embodiments the base roll (with the support) rotates more than 360 degrees, to about 450 degrees, to securely bring the first and second ends at least adjacent one another. In some embodiments after the base roll has traveled at least about 360 degrees and the photosensitive layer is wrapped to contact the sleeve support, the first end and the second end are adjacent and abut against each other. In some embodiments after the base roll has traveled at least about 360 degrees and the photosensitive layer is wrapped to contact the sleeve support, the first end and the second end are adjacent and mate with each other. In some embodiments after the base roll has traveled at least about 360 degrees and the photosensitive layer is wrapped to contact the sleeve support, the first end and the second end are adjacent and overlap one another. In some embodiments, the first and second ends can overlap between about 0.5 to 15mm. In some embodiments, the first and second ends can overlap up to 10mm. In some embodiments after the base roll has traveled at least about 360 degrees and the photosensitive layer is wrapped to contact the sleeve support, the first end and the second end are adjacent and form a small gap with each other. In some embodiments, the gap is less than half the thickness of the photosensitive layer. In other embodiments the gap can be about 0.3 to 1mm.

If the photosensitive layer originated from a photosensitive element for use as a printing plate, and the sheet support or the coversheet (and release layer) remained on an exterior surface of the photosensitive layer opposite the contact surface during contacting, the sheet support or the coversheet is removed after the roll has made a revolution to contact the ends and before fusing of the ends. In one embodiment, the coversheet or the sheet support can be removed as the base roll rotates through its first rotation after the photosensitive layer has contacted the support.

In some embodiments, preheating of the exterior surface and/or the contact surface and laminating can seal and fuse the adjacent ends together. In some embodiments, preheating of the exterior surface and/or the contact surface and laminating can seal the adjacent ends together, and additional heating may be needed to fuse the adjacent ends together. "Seal" or "sealing" of the adjacent ends of the photosensitive layer means that the adjacent ends are sufficiently held together to form a continuous layer on the support, but a line of demarcation, or a seam or joint where the adjacent ends met, is present. In most instances in this embodiment, the seam or joint in sealed adjacent ends will be visible on the exterior surface of the cylindrical photosensitive element. In other cases, the seam or joint in sealed adjacent ends will become apparent during printing. "Fuse" or "fusing" of the adjacent ends of the photosensitive layer means that the adjacent ends are held and bonded together to form a continuous layer on the support, such that a line of demarcation, or a seam or joint where the adjacent ends met, is not present. After laminating and fusing, the photosensitive layer becomes a continuum of photosensitive material and the cylindrical photosensitive element can be considered seamless.

In some embodiments, after contact of the photosensitive layer with the sleeve, the layer and/or the sleeve is no longer heated by the means for preheating as described above. The preheating of the exterior surface and/or the contact surface is sufficient to cause the photosensitive layer to become or maintain its tacky nature to attach to the sleeve, and to soften sufficiently to seal and fuse the adjacent ends together. It is surprising that preheating of the exterior surface of the sleeve support and/or the contact surface of the photosensitive layer is not only capable of attaching the layer to the sleeve without the need for an adhesive or tape, but is also sufficient the adjacent ends to seal and fuse together during laminating.

In some embodiments, after contact of the photosensitive layer with the sleeve, cylindrical photosensitive element is additionally heated by a means for heating. The preheating means for the exterior surface and/or the contact surface described above can also operate as the additional means for heating. The means for preheating may need to be oriented appropriately to function as the additional means for heating. Alternatively, the additional means for heating can be independent of the preheating means. The additional means for heating is not limited and can include conduction, convection, and radiation methods. The preheating of the exterior surface and/or the contact surface is sufficient to cause the photosensitive layer to become or maintain its tacky nature to attach to the sleeve, and to soften sufficiently to seal the adjacent ends together. It is surprising that preheating of the exterior surface of the sleeve support and/or the contact surface of the photosensitive layer is not only capable of attaching the layer to the sleeve without the need for an adhesive or tape, but is also sufficient the adjacent ends to seal adjacent ends together. In this embodiment, the cylindrical photosensitive element, in particular the photosensitive layer on the support, can be heated to a temperature less than the glass transition temperature of the photosensitive layer. It is desirable to additionally heat the cylindrical photosensitive element to the extent sufficient to fuse the adjacent ends under lamination. Because the photosensitive element was preheated, only a minimal additional heating of the photosensitive element may be needed to complete the bond and fuse the adjacent ends together under lamination.

The process includes laminating the photosensitive layer to the support to seal and fuse the ends together to form a continuous layer on the support. The term "laminating", (or lamination, laminated) refers to uniting layers of at least two materials together, that is, laminating attaches or joins the photosensitive layer to the sleeve support to become a unitary structure and form the cylindrically-shaped photosensitive element. The laminating roll contacts the exterior surface of the photosensitive layer and presses to laminate the layer onto the support. In some embodiments, the base roll continues to rotate the sleeve (with the photosensitive layer) while the laminating roll contacts the photosensitive layer and seals and/or fuses the adjacent ends. This embodiment can also help to maintain the thickness uniformity of the photosensitive layer on the cylindrically-shaped support. In some embodiments, the laminating roll contacts the photosensitive layer in only the locale where the adjacent ends are sealing and/or fusing. In this embodiment, the base roll may only partially rotate or the laminating roll may be oriented to pressing contact in the locale of the adjacent ends. The laminating roll can have the same or a different impression setting from the impression setting used during contacting. In some embodiments, the laminating roll can have impression setting between 0 and 1 mm, and in other embodiments, the laminating roll can have an impression setting between 0 and 0.5mm, for laminating and fusing.

During laminating, the first end and the second end are sealing and/or fusing together to form a continuous layer of the photosensitive layer on the cylindrically-shaped support. Fusing is the blending of the adjacent ends together with the material in a plastic, i.e., softened, state. Fusing of the ends can occur with the heat residing in the sleeve and/or the photosensitive layer that was introduced during preheating. The sleeve and/or the photosensitive layer is preheated to a temperature sufficient to effect softening of the layer at least at the ends and render the adjacent ends capable of fusing during laminating. The sleeve and/or layer is preheated to a temperature such that the ends are softened and are capable of fusing in a short time and form the continuous layer. In some embodiments after laminating, the continuous layer has no visible or printable seam at a locale where the ends met, that is the ends have been sealed and fused. Fusing of the ends can be aided with additional heating after the photosensitive layer has contacted the sleeve. After laminating, fusing, and grinding the continuous layer has no visible or printable seam at a locale where the ends met. In some embodiments, the steps of contacting and laminating to seal and fuse the adjacent ends are conducted in the same device.

After the adjacent ends are fused to form the continuous seamless photosensitive layer on the sleeve support, the element can be cooled to room temperature, before removing the cylindrical photosensitive element from the base roll. The cylindrical photosensitive element has axial ends that may be trimmed to the desired length of the element.

Optionally, any nonuniformity in the thickness of the cylindrical photosensitive layer, particularly at the locale where the first and second ends fused, or surface disturbances can be removed by grinding the photosensitive layer to the desired thickness uniformity. Grinding with a grinding stone is a conventional method for removing excess polymeric material to provide desired thickness uniformity.

Optionally, other layers can be applied to an exterior surface of the cylindrically-shaped photosensitive element by the same inventive process or a different process as the photosensitive layer was secured to the sleeve support. Care must be taken for any process of applying additional layers to the exterior surface to operate at a temperature no higher than the highest temperature used in the present process to make the cylindrically- shaped photosensitive element. An example of an additional layer applied to the exterior surface of the element can be an actinic radiation opaque layer suitable for forming an in-situ mask. The actinic radiation opaque layer can be applied to the exterior surface by any means, for example, coating of cylindrical forms as disclosed by Bode et al. in U.S. Patent 6,531,184 and Michels et al. in U.S. Publication No. 2001/0012599 A1.

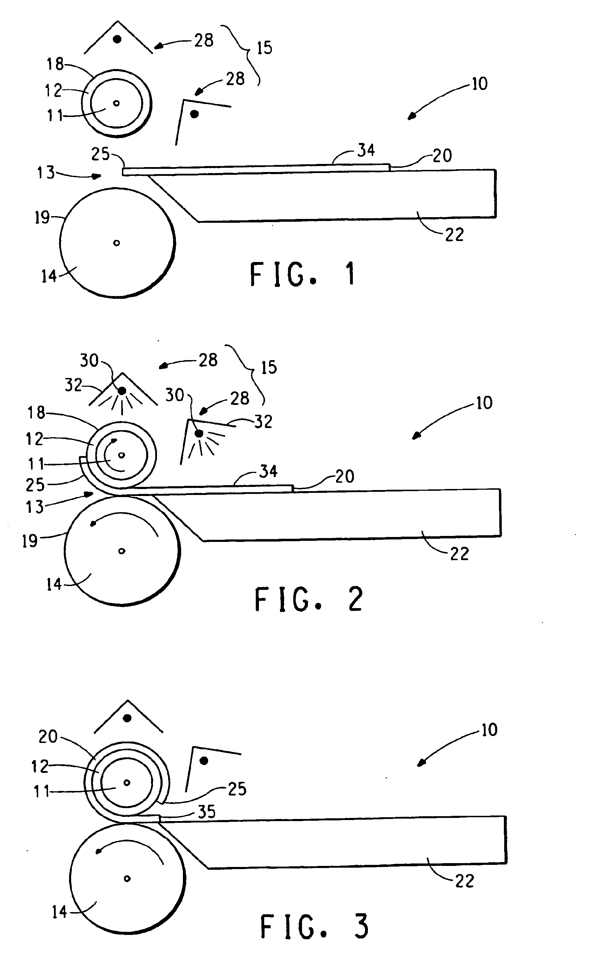

The present process for preparing a cylindrically shaped photosensitive element is conducted in a device that accommodates the cylindrical support and the resulting cylindrically shaped element. A device 10 for making the cylindrically shaped photosensitive element is shown in Figures 1 through 3. The device 10 includes a base roll 11 for supporting the cylindrical (sleeve) support 12, a laminating roll 14 adjacent the base roll 11 and forming a nip 13 with the base roll (or the support on the base roll), and a means for preheating 15 the exterior surface 18 of the support 12 and/or the contact surface of the photosensitive layer. The position of the base roll 11 and/or the laminating roll 14 can be adjusted relative to each other and thus change the distance between the exterior surface 18 of the support 12 (or base roll) and an outer surface 19 of the laminating roll 14 at the nip 13. The capability to adjust the distance between surfaces at the nip 14 accommodates making elements with photosensitive layers of different thickness and with sleeve supports of different wall thickness.

Figure 1 is an embodiment of a step of the present process that shows providing the layer of the photosensitive composition in the nip between the laminating roll and the base roller that is supporting a cylindrically-shaped support. A photosensitive layer 20 resides on a movable table 22 with a first end 25 (or a leading edge) of the photosensitive layer positioned between the base roll 11 holding the cylindrical support sleeve 12 and the laminating roll 14. The moveable table can be considered one embodiment of a means for positioning the photosensitive element to the sleeve 12. The base roll 11 is a means for supporting the sleeve 12, which can encompass embodiments where the base roll is a shaft, a drum, a mandrel, or an adapter mounted on a mandrel. The sleeve 12 is mounted on the base roll 11. The distance from the exterior surface 18 of the sleeve 12 to the outer surface 19 of the laminating roll 14 at the nip 13 initially is greater than the total thickness of the photosensitive layer 20. The photosensitive layer 20 is positioned so that the leading edge 25 of the element is first to enter the nip 13. The moveable table 22 which is adjacent the base roll 11 and the laminating roll 14 may be used to hold and help position the layer 20. The moveable table 22 moves in a first direction parallel to an axis of the base roll 11 and in a second direction perpendicular to the axis of the base roll 11 to correctly locate the photosensitive layer 20 between the sleeve support 12 and the laminating roll 14. The laminating roll 14 and/or the base roll 11 can be moved to capture the first end 25 of the photosensitive layer 20 into the nip 13 between the laminating roll 14 and sleeve support 12.

Figure 2 is an embodiment of a step of the present process showing the means for preheating 15 heating the support 12 and the photosensitive layer 20. One embodiment of a means for preheating 15 the exterior surface 18 of the support 12 and a contact surface 24 of the photosensitive layer 20 is shown as radiant heaters 28, each comprising at least one tubular infrared heating bulb 30, that is mounted in end supports (not shown) connected to a frame of the device 10, and provided with electrical connection to the bulb. Adjacent the side of the bulb 30 is a reflector 32 that acts to focus and direct the infrared radiation toward the exterior surface 18 of the sleeve support 12 and the contact surface 34 of the photosensitive layer. Such a heater 28 having an infrared heating bulb 30 with end supports and a reflector 32 can be obtained from Heraeus Noblelight GmbH, (Hanau, Germany). The base roll 11 can rotate, and thereby rotate the sleeve support 12, so that the entire exterior surface 18 of the sleeve is heated before contact of the photosensitive layer 20 to the sleeve. As the photosensitive layer 20 traverses the table 22, the contact surface 34 of the layer is heated before contact with the sleeve.

In an alternate embodiment for the means for preheating 15, a single radiant heater 28 can be used to preheat the sleeve 12 and/or the photosensitive layer 20. The heater 28, including the reflector 32, can be mounted on the device 10 such that the heater rotates it s position to accommodate preheating the sleeve 12 and/or the photosensitive layer 20.

Figure 2 also shows an embodiment of contacting the contact surface 34 of the photosensitive layer 20 to the exterior surface 18 of the sleeve support 12, particularly contacting a leading portion of the photosensitive layer to the sleeve. The base roll 11 and/or the laminating roll 14 can include means for moving relative to the other (not shown). The leading edge 25 of the photosensitive layer 20 and the sleeve support located at the nip 13 have been preheated before the base roll 11 and the laminating roll 14 capture the leading edge 25 of the photosensitive layer 20 in the nip 13. The photosensitive layer 20 and the sleeve 12 not yet contacting each other, i.e., noncontacting portions of the layer and the sleeve, may continue to be preheated by the heaters 28. At least the laminating roll 14 includes a means for pressing (not shown) the roll against the photosensitive layer 20 (that is contacting the sleeve support 12). It is well within the skill of those in the art to provide a suitable embodiment for the means for pressing the laminating roll 14, examples of which include, but are not limited to, tensioning springs, actuating cylinders, rotation-to-translation mechanisms to maintain the displacement gap at the nip with impression setting, and translation-to-translation mechanisms to maintain the displacement gap at the nip with impression setting.

Figures 2 and 3 depict an embodiment of a step of the present process showing contacting the photosensitive layer onto the support. The base roll 11 is rotating and thereby rotating the support 12 to mount and attach the photosensitive layer 20 to the exterior surface 18 of the support. The photosensitive layer 20 may include a coversheet or a sheet support (not shown) on the side opposite the contact surface 34 of the layer. At the nip 13, the contact surface 34 of the photosensitive layer 20 contacts the exterior surface 18 of the sleeve support 12 and attaches to the support. The photosensitive layer 20 travels with the support as it is rotated on the base roll 11. As the base roll 11 completes or just passes its full rotation, the first end 25 of the photosensitive layer 20 is brought at least adjacent to a second end 35 of the layer, forming a cylindrical but somewhat discontinuous layer of photosensitive material on the support 12.

The base roll 11 continues rotating the support 12 with the photosensitive layer 20 as the laminating roll 14 presses in contact for a time to laminate the layer to the support and fuse the adjacent ends. Fusing the ends of the photosensitive layer 20 forms the continuous layer of the photosensitive material on the support. In one embodiments of laminating, the laminating roll 14 remains in contact with the photosensitive layer 20 and the base roll 11 continues rotating the support 12 to maintain the thickness uniformity of the layer and to fuse the adjacent.

A device for making cylindrically-shaped photosensitive elements can be derived from apparatuses for mounting flexographic printing plates onto a printing cylinder which have been disclosed, for example, in EP 0 329 228 A1 and U.S. Patents 5,488,781, 4,872,407, and 4,520,389. Further, a commercial apparatus for mounting flexographic printing plates onto printing cylinders is available as CYREL® Microflex mounting and proofing system by DuPont (Wilmington, DE). The flexographic printing plate which is mounted onto a print cylinder by a conventional mounting apparatus has already undergone the steps of imagewise exposure and treatment to form the relief printing surface on the plate, and therefore does not have some of the concerns associated with making cylindrically shaped photosensitive elements, such as forming the photosensitive layer into a cylinder and fusing adjacent ends. It is within the skill of one in the art to modify mounting apparatuses which are used to mount printing plates onto printing cylinders, according to the present description, to accommodate joining of raw, i.e., unexposed, photosensitive layer onto a support. In some embodiments, the steps of contacting and laminating to at least seal and optionally fuse the adjacent ends are conducted in the same device.

The present process has particular advantages since an adhesive layer or tape is not needed between exterior surface of the sleeve and the photopolymerizable layer to facilitate the attachment of the photopolymerizable layer to the sleeve support. Preheating the exterior surface of the sleeve and/or the contact surface of the photosensitive layer, prior to contact of the photosensitive layer with the support, avoids the use of adhesive. This simplifies the process for making the cylindrically shaped photosensitive element by eliminating extra step of applying the adhesive material or tape. This also avoids the potential for defects, such as bubbles, streaks, etc. caused by the application of the adhesive, which can further induce defects in the resulting printing form. Surprisingly, the present process which only preheats the photosensitive layer and/or the cylindrically-shaped support is capable of fusing ends of the photosensitive layer together to form a continuous layer on the support.

### Photosensitive Composition

The photosensitive element includes a layer of a photopolymerizable composition comprising an thermoplastic binder, at least one monomer, and a photoinitiator. The photosensitive layer may also be referred to herein as a photopolymerizable layer. As used herein, the term "photopolymerizable" is intended to encompass systems that are photopolymerizable, photocrosslinkable, or both. The photoinitiator has sensitivity to actinic radiation.

The photopolymerizable layer is a solid elastomeric layer formed of the composition comprising a thermoplastic binder, at least one monomer, and a photoinitiator. The photoinitiator has sensitivity to actinic radiation. Throughout this specification actinic radiation will include ultraviolet radiation and/or visible light. The solid layer of the photopolymerizable composition is treated with one or more solutions and/or heat to form a relief suitable for flexographic printing. As used herein, the term "solid" refers to the physical state of the layer which has a definite volume and shape and resists forces that tend to alter its volume or shape.

The thermoplastic binder can be a single polymer or mixture of polymers. The thermoplastic binder preferably is elastomeric. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. Preferably, the thermoplastic binder is an elastomeric block copolymer of an A-B-A type block copolymer, where A represents a non-elastomeric block, preferably a vinyl polymer and most preferably polystyrene, and B represents an elastomeric block, preferably polybutadiene or polyisoprene. Preferred thermoplastic elastomeric binders are poly(styrene/isoprene/styrene) block copolymers and poly(styrene/butadiene/styrene) block copolymers. The non-elastomer to elastomer ratio of the A-B-A type block copolymers is preferably in the range of from 10:90 to 35:65. The thermoplastic binder can be soluble, swellable, or dispersible in aqueous, semi-aqueous, water, or organic solvent washout solutions. Elastomeric binders which can be washed out by treating in aqueous or semi-aqueous developers have been disclosed by Proskow, in U.S. Patent 4,177,074; Proskow in U.S. Patent 4,431,723; Worns in U.S. Patent 4,517,279; Suzuki et al. in U.S. 5,679,485; Suzuki et al. in U.S. 5,830,621; and Sakurai et al. in U.S. 5,863,704. The block copolymers discussed in Chen, U.S. Patent 4,323,636; Heinz et al., U.S. Patent 4,430,417; and Toda et al., U.S. Patent 4,045,231 can be washed out by treating in organic solvent solutions. Generally, the thermoplastic binders which are suitable for washout development are also suitable for use in thermal treating wherein the unpolymerized areas of the photopolymerizable layer soften, melt, or flow upon heating. The binder is present in an amount of at least 50 % by weight of the photosensitive composition.

The term binder, as used herein, encompasses core shell microgels and blends of microgels and preformed macromolecular polymers, such as those disclosed in Fryd et al., U.S. Patent 4,956,252 and Quinn et al., U.S. Patent 5,707,773.

Other suitable photosensitive elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete description of some of these materials see U.S. Pat. No. 5,015,556.

The photopolymerizable composition contains at least one compound capable of addition polymerization that is compatible with the binder to the extent that a clear, non-cloudy photosensitive layer is produced. The at least one compound capable of addition polymerization may also be referred to as a monomer and can be a single monomer or mixture of monomers. Monomers that can be used in the photopolymerizable composition are well known in the art and include, but are not limited to, addition-polymerization ethylenically unsaturated compounds with at least one terminal ethylenic group. Examples of suitable monomers include, but are not limited to, acrylate and methacrylate mono-esters of alcohols and polyols, and acrylate and methacrylate poly-esters of alcohols and polyols. Examples of alcohols and polyols include alkanols; alkylene glycols; trimethylol propane; pentaerythritol; dipentaerythritol; polyacrylol oligomers, and the like. A mixture of monofunctional and multifunctional acrylates or methacrylates may be used. Other examples of suitable monomers include acrylate and methacrylate derivatives of isocyanates, esters, epoxides and the like. Monomers can be appropriately selected by one skilled in the art to provide elastomeric property to the photopolymerizable composition. Examples of elastomeric monomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than 20% by weight). Further examples of monomers can be found in Chen U.S. Patent No. 4,323,636; Fryd et al., U.S. Patent No. 4,753,865; Fryd et al., U.S. Patent No. 4,726,877 and Feinberg et al., U.S. Patent No. 4,894,315. The compound capable of addition polymerization (monomer) is present in at least an amount of 5%, preferably 10 to 20%, by weight of the elastomeric composition.

The photoinitiator can be any single compound or combination of compounds which is sensitive to actinic radiation, generating free radicals which initiate the polymerization of the monomer or monomers without excessive termination. The photoinitiator is activated by the actinic radiation, having sensitivity to the radiation in accordance with its absorption spectrum. The absorption spectrum of the photoinitiator typically includes an absorption peak at a wavelength of maximum absorption to the actinic radiation. Photosensitive elements for use as flexographic printing forms that are sensitive to these particular UV sources typically use photoinitiators that absorb between 310-400 nm. Any of the known classes of photoinitiators, particularly free radical photoinitiators such as quinones, benzophenones, benzoin ethers, aryl ketones, peroxides, biimidazoles, benzyl dimethyl ketal, hydroxyl alkyl phenyl acetophone, dialkoxy actophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, sulfonyl ketones, benzoyl oxime esters, thioxanthrones, camphorquinones, ketocouumarins, Michler's ketone may be used. Alternatively, the photoinitiator may be a mixture of compounds, one of which provides the free radicals when caused to do so by a sensitizer activated by radiation. In one embodiment, the initiator is sensitive to ultraviolet radiation. In another embodiment, the initiator is sensitive to visible radiation. Photoinitiators are generally present in amounts from 0.001 % to 10.0% based on the weight of the photopolymerizable composition.

The photopolymerizable composition can contain other additives depending on the final properties desired. Additional additives to the photopolymerizable composition include sensitizers, plasticizers, rheology modifiers, thermal polymerization inhibitors, colorants, processing aids, antioxidants, antiozonants, and fillers.

The thickness of the photosensitive layer can vary over a wide range depending upon the type of printing form desired, for example, from about 0.020 inches to about 0.250 inches or greater (about 0.05 cm to about 0.64 cm or greater). In some embodiments, the thickness of the photosensitive layer provided is greater than the thickness of the continuous photosensitive layer on the sleeve support.

The photopolymerizable layer itself can be prepared in many ways by admixing the binder, monomer, photoinitiator, and other ingredients. In some embodiments where the photosensitive layer originates from a photosensitive plate, the photopolymerizable mixture can be formed into a hot melt and then calendered to the desired thickness. An extruder can be used to perform the functions of melting, mixing, deaerating and filtering the composition. The extruded mixture can then be calendered between the support and a temporary coversheet. Alternatively, the photopolymerizable material can be placed between the support and the temporary coversheet in a mold. The layers of material are then pressed flat by the application of heat and/or pressure.

In one embodiment the cylindrically-shaped photosensitive element further includes an infrared (IR)-sensitive layer on top of the photosensitive layer (or other layers if present). The IR-sensitive layer can form an integrated masking layer for the photosensitive element. The preferred IR-sensitive layer is opaque to actinic radiation that is, has an optical density of at least 1.5 ; can be imaged, preferably by ablating, with an infrared laser; and removable during treating, i.e., soluble or dispersible in a developer solution or during thermal development. The IR sensitive layer contains material having high absorption in the wavelength (infrared range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. To achieve the desired optical density to block actinic radiation, the infrared-sensitive layer contains a material that prevents the transmission of actinic radiation. In some embodiments, the optical density can be between 2.0 and 3.0. In some embodiments, the optical density can be between 2.6 and 3.4. This actinic radiation blocking material can be the same or different than the infrared absorbing material, and can be, for example, dyes or pigments, and in particular the aforesaid inorganic pigments. The quantity of this material is usually 1-70 % by weight relative to the total weight of the layer. The infrared-sensitive layer optionally includes a polymeric binder, such as, for example, nitrocellulose, homopolymers or copolymers of acrylates, methacrylates and styrenes, polyamides, polyvinyl alcohols, etc. Other auxiliary agents, such as plasticizers, coating aids, etc. are possible. The infrared-sensitive layer is usually prepared by coating a solution or dispersion of the aforesaid components as a layer on the photosensitive layer, and subsequently drying it. The thickness of the infrared-sensitive layer is usually 2 nm to 50 µm, preferably 4 nm to 40 µm. These infrared-sensitive layers and their preparation are described in detail, for example in WO 94/03838 and WO 94/3839.

The cylindrically-shaped photosensitive element is converted to the cylindrically-shaped printing form by undergoing conventional steps of exposing (including imagewise exposure and optionally backflash exposure) and treating to form a relief surface on the printing form suitable for flexographic printing.

The exposure process usually comprises a back exposure and a front image-wise exposure, although the former is not strictly necessary. The back exposure or "backflash" can take place before, after or during image-wise exposure. Backflash prior to image-wise exposure is generally preferred.

Upon imagewise exposure, the radiation-exposed areas of the photosensitive layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps. Typically, a mercury vapor arc or a sunlamp can be used at a distance of about 1.5 to about 60 inches (about 3.8 to about 153 cm) from the photosensitive element. These radiation sources generally emit long-wave UV radiation between 310-400 nm. The exposure time may vary from a few seconds to minutes, depending upon the intensity and spectral energy distribution of the radiation, its distance from the photosensitive element, and the nature and amount of the photopolymerizable material.

Imagewise exposure can be carried out by exposing the photosensitive element through an image-bearing photomask. The photomask can be a separate film, i.e., an image-bearing transparency or phototool, such as a silver halide film; or the photomask can be integrated with the photosensitive element as described above. In the case in which the photomask is a separate film, the optional cover sheet is usually stripped before imagewise exposure leaving the release layer on the photosensitive element. The photomask is brought into close contact with the release layer of the photosensitive element by the usual vacuum processes, e.g., by use of a common vacuum frame. Thus a substantially uniform and complete contact between the photosensitive element and the photomask can be achieved in acceptable time.

It is preferred to form the integrated photomask on the cylindrical photosensitive element. In a particularly preferred embodiment, the photosensitive element includes the IR-sensitive layer which becomes the integrated photomask. The IR-sensitive layer is imagewise exposed to IR laser radiation to form the photomask on the photosensitive element. The infrared laser exposure can be carried out using various types of infrared lasers, which emit in the range 750 to 20,000 nm. Infrared lasers including, diode lasers emitting in the range 780 to 2,000 nm and Nd:YAG lasers emitting at 1064 nm are preferred. In so-called digital imaging, the radiation opaque layer is exposed imagewise to infrared laser radiation to form the image on or disposed above the photopolymerizable layer, i.e., the in-situ mask. The infrared laser radiation can selectively remove, e.g., ablate or vaporize, the infrared sensitive layer (i.e., radiation opaque layer) from the photopolymerizable layer, as disclosed by Fan in U.S. Patents 5,262,275 and 5,719,009; and Fan in EP 0 741 330 B1. The integrated photomask remains on the photosensitive element for subsequent steps of UV pre-exposure, imagewise main exposure to actinic radiation and development.

In an alternate embodiment of digital method of mask formation, the photosensitive element will not initially include an infrared sensitive layer. In this case the infrared sensitive layer is the same as or substantially the same as the infrared sensitive layer included with the photosensitive layer as described above. A separate element bearing the infrared sensitive layer will form an assemblage with the photosensitive element such that the infrared sensitive layer is adjacent the surface of the photosensitive element opposite the support, which is typically the photopolymerizable layer. The separate element may include one or more other layers, such as ejection layers or heating layers, to aid in the digital exposure process. The assemblage is exposed imagewise with infrared laser radiation to selectively transfer the infrared sensitive layer and form the image on or disposed above the photopolymerizable layer as disclosed by Fan et al. in U.S. Patent 5,607,814; and Blanchett in U.S. Patents 5,766,819; 5,840,463; and EP 0 891 877 A. Only the portions of the infrared sensitive layer which were transferred will reside on the photosensitive element forming the *in situ* mask.

Further, the mask image may be created on a separate carrier and then transferred by application of heat and/or pressure to the surface of the photopolymerizable layer opposite the support. The photopolymerizable layer is typically tacky and will retain the transferred image. The separate carrier can then be removed from the element prior to the pre-exposure and/or the imagewise exposure. The separate carrier may have an infrared sensitive layer that is imagewise exposed to laser radiation to selectively remove the material and form the image. An example of this type of carrier is LaserMask^{®} imaging film by Rexam, Inc.

It is also contemplated that digital mask formation can be accomplished by imagewise application of the radiation opaque material in the form of inkjet inks. Imagewise application of an ink-jet ink can be directly on the photopolymerizable layer or disposed above the photopolymerizable layer of the photosensitive element.

Following overall exposure to UV radiation through the image-bearing mask, the photosensitive element is treated to remove unpolymerized areas in the photopolymerizable layer and thereby form a relief image. Treatment of the photosensitive printing element can include
(1) "wet" development wherein the photopolymerizable layer is contacted with a suitable developer solution to washout unpolymerized areas and
(2) "dry" development wherein the photopolymerizable layer is heated to a development temperature which causes the unpolymerized areas to melt or soften and is contacted with an absorbant material to wick away the unpolymerized material. Dry development may also be called thermal development. Wet development is usually carried out at about room temperature. The developer solution can include an organic solvent, an aqueous or a semi-aqueous solution, or water. The choice of the developer solution will depend primarily on the chemical nature of the photopolymerizable composition to be removed. A suitable organic solvent developer includes an aromatic or an aliphatic hydrocarbon, an aliphatic or an aromatic halohydrocarbon solvent, or a mixture of such solvents with a suitable alcohol. Other organic solvent developers have been disclosed in published German Application 38 28 551. A suitable semi-aqueous developer can contain water and a water miscible organic solvent and an alkaline material. A suitable aqueous developer can contain water and an alkaline material. Other suitable aqueous developer solution combinations are described in U.S. Patent No. 3,796,602.

Development time can vary, but it is preferably in the range of about 2 to about 25 minutes. The developer solution can be applied in any convenient manner, including immersion, spraying, and brush or roller application. Brushing aids can be used to remove the unpolymerized portions of the photosensitive printing element. Washout can be carried out in an automatic processing unit which uses developer and mechanical brushing action to remove the unexposed portions of the resulting flexographic printing plate, leaving a relief constituting the exposed image and the floor.

Following treatment by developing in solution, the flexographic printing forms are generally blotted or wiped dry, and then more fully dried in a forced air or infrared oven. Drying times and temperatures may vary, however, typically the plate can be dried for about 60 minutes to about 120 minutes at about 60°C. High temperatures are not recommended because the support can shrink, and this can cause registration problems.

In thermal development, the photopolymerizable layer can be heated to a development temperature typically between about 40°C and 200°C which causes the unpolymerized areas to liquefy, that is, to melt or flow. The photopolymerizable layer can then be contacted with a development material to remove the unpolymerized photopolymerizable composition. The polymerized areas of the photopolymerizable layer have a higher melting temperature than the unpolymerized areas and therefore do not melt at the development temperatures (see U.S. 5,215,859 and WO 98/13730). Apparatus suitable for thermal development of photosensitive printing elements is disclosed in U.S. 5,279,697 and U.S. 6,797,454.

In another alternate embodiment the imaging element may be suitably reinforced and then imagewise exposed to laser radiation to engrave or remove the reinforced layer in depth imagewise. U.S. Patents No. 5,798,202; U.S. 5,804,353; and U.S. 6,757,216 B2 disclose suitable processes for making a flexographic printing plate by laser engraving a reinforced elastomeric layer on a flexible support. The processes disclosed in U.S. Patents No. 5,798,202 and 5,804,353 involve reinforcing and laser engraving a single-layer, or one or more layers of a multi-layer, of a flexographic printing element comprised of a reinforced elastomeric layer on a flexible support. The elastomeric layer is reinforced mechanically, or thermochemically, or photochemically or combinations thereof. Mechanical reinforcement is provided by incorporating reinforcing agents, such as finely divided particulate material, into the elastomeric layer. Photochemical reinforcement is accomplished by incorporating photohardenable materials into the elastomeric layer and exposing the layer to actinic radiation. Photohardenable materials include photocrosslinkable and photopolymerizable systems having a photoinitiator or photoinitiator system.

The flexographic printing forms made using the cylindrically-shaped photosensitive element can be uniformly post-exposed to ensure that the photopolymerization process is complete and that the printing form will remain stable during printing and storage. This post-exposure step can utilize the same radiation source as the main exposure.

Detackification is an optional post-development treatment which can be applied if the surface of the flexographic printing plate is still tacky, such tackiness not generally being removed in post-exposure. Tackiness can be eliminated by methods well known in the art, such as treatment with bromine or chlorine solutions, and by exposure to radiation sources having a wavelength not longer than 300 nm.

## Claims

1. A process for making a cylindrically-shaped photosensitive element for use as a printing form, comprising:
a) providing a cylindrically-shaped support having an exterior surface, **characterised in that**
no tape or adhesive material is provided on the exterior surface of the support;
b) providing a photosensitive layer comprising a thermoplastic binder, monomer, and photoinitiator, the layer having a first end and a second end opposite the first end joined by a contact surface;
c) contacting the contact surface of the photosensitive layer to the exterior surface of the support by wrapping the photosensitive layer around the support to bring the second end adjacent the first end; and
d) laminating the photosensitive layer to the support and sealing the ends together to form a continuous layer on the support;
wherein a preheating step is performed prior to the contacting step and is selected from the group consisting of 1) preheating the exterior surface of the support to a temperature greater than 39°C; 2) preheating the contact surface of the photosensitive layer to a temperature less than its glass transition temperature; and a combination of 1) and 2).

2. The process of Claim 1 further comprising fusing the ends together during laminating.

3. The process of Claim 1 further comprising, after the contacting step, heating the photosensitive layer to a temperature sufficient for fusing the sealing ends together during laminating.

4. The process of Claim 1 further comprising grinding a surface of the photosensitive layer opposite the support after the laminating step d).

5. The process of Claim 1 wherein the preheating of the exterior surface of the support is to a temperature between 40 and 105°C.

6. The process of Claim 1 wherein the preheating of the contact surface of the photosensitive layer is to a temperature between 40 and 100°C.

7. The process of Claim 1 wherein the preheating is selected from the group consisting of conduction, convection, radiation, and combinations thereof.

8. The process of Claim 1 further comprising trimming the first end and second end to mate with each other.

9. The process of Claim 1 wherein after contacting step c) the second end mates, abuts, overlaps, or forms a gap with the first end.

10. The process of Claim 1 further comprising prior to preheating, overall exposing the contact surface of the photosensitive layer to actinic radiation to form a floor for the photosensitive element.

11. The process of Claim 1 wherein the support is selected from the group consisting of fiber-reinforced polymeric resin or plastic and filler-reinforced polymeric resin or plastic.

12. The process of Claim 1 wherein the support is selected from the group consisting of polymeric films formed by addition polymers, polymeric films formed by linear condensation polymers, metals, foams, and fiberglass.

13. The process of Claim 1 wherein the laminating step comprises rotating the support having the photosensitive layer and contacting an exterior surface of the photosensitive layer opposite the support with a laminating roll.

## Patentansprüche

1. Verfahren zum Herstellen eines zylindrisch geformten lichtempfindlichen Elements zur Verwendung als Druckform, wobei das Verfahren Folgendes umfasst:
a) das Bereitstellen eines zylindrisch geformten Trägers, der eine Außenfläche aufweist, **dadurch gekennzeichnet, dass**
kein Band oder Klebematerial auf der Außenfläche des Trägers bereitgestellt wird,
b) das Bereitstellen einer lichtempfindlichen Schicht, die ein thermoplastisches Bindemittel, ein Monomer und einen Photoinitiator umfasst, wobei die Schicht ein erstes Ende und ein zweites Ende, gegenüber dem ersten Ende, aufweist, die durch eine Berührungsfläche verbunden sind,
c) das In-Berührung-Bringen der lichtempfindlichen Schicht mit der Außenfläche des Trägers durch das Wickeln der lichtempfindlichen Schicht um den Träger, um das zweite Ende anliegend an das erste Ende zu bringen, und
d) das Laminieren der lichtempfindlichen Schicht auf den Träger und das Siegeln der Enden aneinander, um eine durchgehende Schicht auf dem Träger zu bilden, wobei vor dem Schritt des In-Berührung-Bringens ein Vorwärmungsschritt ausgeführt wird und ausgewählt ist aus der Gruppe, die aus 1) dem Vorwärmen der Außenfläche des Trägers auf eine Temperatur, die größer ist als 39°C, 2) dem Vorwärmen der Berührungsfläche der lichtempfindlichen Schicht auf eine Temperatur, die geringer ist als ihre Glasübergangstemperatur, und einer Kombination von 1) und 2) besteht.

2. Verfahren nach Anspruch 1, das ferner das Verschmelzen der Enden miteinander während des Laminierens umfasst.

3. Verfahren nach Anspruch 1, das ferner, nach dem Schritt des In-Berührung-Bringens, das Erwärmen der lichtempfindlichen Schicht auf eine Temperatur, die dazu ausreicht, die versiegelnden Enden während des Laminierens miteinander zu verschmelzen, umfasst.

4. Verfahren nach Anspruch 1, das ferner das Schleifen einer Oberfläche der lichtempfindlichen Schicht, die dem Träger gegenüberliegt, nach dem Laminierungsschritt d) umfasst.

5. Verfahren nach Anspruch 1, wobei das Vorwärmen der Außenfläche des Trägers auf eine Temperatur zwischen 40 und 105°C erfolgt.

6. Verfahren nach Anspruch 1, wobei das Vorwärmen der Berührungsfläche der lichtempfindlichen Schicht auf eine Temperatur zwischen 40 und 100°C erfolgt.

7. Verfahren nach Anspruch 1, wobei das Vorwärmen ausgewählt ist aus der Gruppe, die aus Leitung, Konvektion, Strahlung und Kombinationen derselben besteht.

8. Verfahren nach Anspruch 1, das ferner das Beschneiden des ersten und des zweiten Endes, damit sie aneinanderpassen, umfasst.

9. Verfahren nach Anspruch 1, wobei nach dem Schritt c) des In-Berührung-Bringens das zweite Ende mit dem ersten Ende aneinanderpasst, aneinanderstößt, überlappt oder einen Spalt bildet.

10. Verfahren nach Anspruch 1, das ferner vor dem Vorwärmen das allumfassende Behandeln der Berührungsfläche der lichtempfindlichen Schicht mit chemisch wirksamer Strahlung umfasst, um einen Boden für das lichtempfindliche Element zu bilden.

11. Verfahren nach Anspruch 1, wobei der Träger ausgewählt ist aus der Gruppe, die aus faserverstärktem Polymerharz oder Kunststoff und füllstoffverstärktem Polymerharz oder Kunststoff besteht.

12. Verfahren nach Anspruch 1, wobei der Träger ausgewählt ist aus der Gruppe, die aus durch Additionspolymere geformten Polymerfolien, durch lineare Kondensationspolymere geformten Polymerfolien, Metallen, Schaumstoffen und glasfaserverstärktem Kunststoffbesteht.

13. Verfahren nach Anspruch 1, wobei der Laminierungsschritt das Drehen des Trägers, der die lichtempfindliche Schicht aufweist, und das In-Berührung-Bringen einer dem Träger entgegengesetzten Außenfläche der lichtempfindlichen Schicht mit einer Laminierwalze umfasst.

## Revendications

1. Procédé de formation d'un élément photosensible de forme cylindrique destiné à être utilisé comme forme d'impression, comprenant les étapes ci-dessous ;
a) fourniture d'un support de forme cylindrique, comportant une surface externe, **caractérisé en ce que**
aucune bande ou aucun matériau adhésif n'est agencée sur la surface externe du support ;
b) fourniture d'une couche photosensible, comprenant un liant thermoplastique, un monomère et un photo-initiateur, la couche comportant une première extrémité et une deuxième extrémité opposée à la première extrémité, reliées par une surface de contact ;
c) mise en contact de la surface de contact de la couche photosensible avec la surface externe du support en enroulant la couche photosensible autour du support, pour amener la deuxième extrémité en un point adjacent à la première extrémité ; et
d) application par stratification de la couche photosensible sur le support et assemblage étanche des extrémités pour former une couche continue sur le support ;
une étape de préchauffage étant effectuée avant l'étape de mise en contact, et étant sélectionnée dans le groupe constitué de 1) un préchauffage de la surface externe du support à une température supérieure à 39°C ; 2) un préchauffage de la surface de contact de la couche photosensible à une température inférieure à sa température de transition vitreuse ; et une combinaison des traitements 1) et 2).

2. Procédé selon la revendication 1, comprenant en outre l'étape d'assemblage des extrémités par fusion au cours de la stratification.

3. Procédé selon la revendication 1, comprenant en outre, après l'étape de mise en contact, l'étape de chauffage de la couche photosensible à une température suffisante pour assembler par fusion les extrémités d'étanchéité au cours de la stratification.

4. Procédé selon la revendication 1, comprenant en outre l'étape de meulage d'une surface de la couche photosensible opposée au support après l'étape de stratification d).

5. Procédé selon la revendication 1, dans lequel la surface externe du support est préchauffée à une température comprise entre 40 et 105°C.

6. Procédé selon la revendication 1, dans lequel la surface de contact de la couche photosensible est préchauffée à une température comprise entre 40 et 100°C.

7. Procédé selon la revendication 1, dans lequel le préchauffage est sélectionné dans le groupe constitué d'une conduction, d'une convection, d'un rayonnement et d'une combinaison de ces traitements.

8. Procédé selon la revendication 1, comprenant en outre l'étape d'ajustement de la première extrémité et de la deuxième extrémité en vue d'une adaptation mutuelle.

9. Procédé selon la revendication 1, dans lequel, après l'étape de mise en contact c), la deuxième extrémité est adaptée à la première extrémité, bute contre celle-ci, chevauche celle-ci ou forme un espace par rapport à celle-ci.

10. Procédé selon la revendication 1, comprenant en outre, avant le préchauffage, l'étape d'exposition globale de la surface de contact de la couche photosensible à un rayonnement actinique pour former une base pour l'élément photosensible.

11. Procédé selon la revendication 1, dans lequel le support est sélectionné dans le groupe constitué d'une résine polymère renforcée par fibres ou de plastique et de résine polymère renforcée d'une charge ou de plastique.

12. Procédé selon la revendication 1, dans lequel le support est sélectionné dans le groupe constitué de films polymères formés par des polymères d'addition, de films polymères formés par des polymères à condensation linéaire, de métaux, de mousse ou de fibres de verre.

13. Procédé selon la revendication 1, dans lequel l'étape de stratification comprend la rotation du support comportant la couche photosensible et la mise en contact d'une surface externe de la couche photosensible opposée au support avec un rouleau de stratification.
